Europäisches Patentamt

European Patent Office

Office européen des brevets

(19)

(11) **EP 1 291 927 A2**

(12) **EUROPÄISCHE PATENTANMELDUNG**

(43) Veröffentlichungstag:
    **12.03.2003 Patentblatt 2003/11**

(51) Int Cl.⁷: $H01L\ 31/032$, $H01L\ 31/18$

(21) Anmeldenummer: **02019071.6**

(22) Anmeldetag: **28.08.2002**

(84) Benannte Vertragsstaaten:
    **AT BE BG CH CY CZ DE DK EE ES FI FR GB GR IE IT LI LU MC NL PT SE SK TR**
    Benannte Erstreckungsstaaten:
    **AL LT LV MK RO SI**

(30) Priorität: **31.08.2001 DE 10142632**
    **28.05.2002 DE 10223744**

(71) Anmelder: **BASF AKTIENGESELLSCHAFT**
    **67056 Ludwigshafen (DE)**

(72) Erfinder:
    • **Sterzel, Hans-Josef, Dr.**
      **67125 Dannstadt-Schauernheim (DE)**
    • **Kühling, Klaus, Dr.**
      **67112 Mutterstadt (DE)**

(74) Vertreter: **Isenbruck, Günter, Dr.**
    **Isenbruck, Bösl, Hörschler, Wichmann, Huhn, Patentanwälte**
    **Theodor-Heuss-Anlage 12**
    **68165 Mannheim (DE)**

(54) **Photovoltaisch aktive Materialien und diese enthaltende photovoltaischen Zellen**

(57) In einer Photovoltaik-Zelle mit einem photovoltaisch aktiven Halbleitermaterial aus mehreren Metallen oder Metalloxiden ist das photovoltaisch aktive Material ausgewählt aus einem
p- oder n-dotierten Halbleitermaterial aus einer ternären Verbindung der allgemeinen Formel (I)

$$Me_x S^A_y S^B_z \qquad (I)$$

mit

Me = Al, Ti, Zr, V, Nb, Ta, Cr, Mo, W, Mn, Fe, Co, Ni, Cu oder Ag,

$S^A$, $S^B$ = B, C, Si, Ge, Sb, Se oder Te,
wobei $S^A$ und $S^B$ jeweils aus verschiedenen Gruppen des Periodensystems der Elemente stammen,

x, y, z unabhängig voneinander sind und Werte von 0,01 bis 1 annehmen können, und wobei der Gewichtsanteil von $S^A$ und $S^B$ zusammen mehr als 30 % beträgt, bezogen auf das gesamte Halbleitermaterial,

oder einem Mischoxid der allgemeinen Formel (II)

$$[(CaO)_u \cdot (SrO)_v \cdot (BaO)_w \cdot (1/2\ Bi_2O_3)_x]_f \cdot \frac{2n+a}{2} \cdot (\{k\}\ Me^n O_{\frac{n}{2}} \cdot \{2\text{-}k\} \cdot Me^{n+a} O_{\frac{n+a}{2}}) \qquad (11)$$

mit

Me = Fe, Cu, V, Mn, Sn, Ti, Mo, W

n = ganze Zahl von 1 bis 6,

a = 1 oder 2,

f = Zahl von 0,2 bis 5,

EP 1 291 927 A2

k = Zahl von 0,01 bis 2,

u+v+w+x= 1.

**Beschreibung**

Die Erfindung betrifft photovoltaisch aktive Materialien und diese enthaltende Photovoltaik-Zellen.

Photovoltaik-Zellen werden seit längerer Zeit zur Gewinnung von elektrischer Energie aus Sonnenlicht eingesetzt. Dabei werden bislang insbesondere kristalline Silizium-Solarzellen eingesetzt, deren Wirkungsgrad in den letzten 15 Jahren um über 50% gesteigert werden konnte. Die bislang verfügbaren Solarzellen weisen jedoch immer noch ein verbesserungswürdiges Eigenschaftsspektrum auf.

Die zur Zeit besten kommerziell erhältlichen Photovoltaik-Zellen weisen Wirkungsgrade von nur 17 - 18% auf. Rein theoretisch sind bei siliciumbasierten Zellen Wirkungsgrade bis 33% erzielbar. Eine Beschreibung des gegenwärtigen Standes bei der Entwicklung von Solarzellen findet sich in M. A. Green et al., Solar Energy Materials & Solar Cells 65 (2001), Seiten 9-16 und M. A. Green, Materials Science and Engineering B74 (2000), Seiten 118-124.

Der maximale Wirkungsgrad bei der Umwandlung von Sonnenlicht in elektrische Energie beträgt aus thermodynamischen Gründen etwa 93%. Eine Reihe von Mechanismen sorgt dafür, dass durch Photonen getrennte Elektronen-Loch-Paare wieder rekombinieren, wodurch der Wirkungsgrad stark erniedrigt wird.

Die Elektronen, die durch die eingestrahlten Photonen aus dem Valenzband des Halbleiters in das Leitungsband angehoben werden, weisen zunächst noch die zusätzliche Energie auf, die der Energie des Photons abzüglich der Bandlücke entspricht. Der Energieüberschuß geht vornehmlich strahlungslos durch Stöße mit Gitterschwingungen verloren, wobei sich das Material erwärmt. Schließlich rekombinieren die Ladungsträger in statistischer Weise unter weiterem Wirkungsgradverlust. Unter Berücksichtigung sämtlicher Verlustmechanismen lassen sich mit Silicium als photovoltaisches Material maximale Wirkungsgrade von etwa 33% erzielen.

Eine wesentliche Aufgabe in der Materialforschung besteht gegenwärtig darin, photovoltaisch aktive Materialien aufzufinden, die diese Verlustmechanismen in weit geringerem Maße aufweisen.

Lösungswege hierfür sind Materialien mit einer Vielzahl von Unterbändern in der Valenzbandstruktur, die durch Photonen von hohen bis niedrigen Wellenlängen angeregt werden, um damit jeweils Elektronen in das Leitungsband zu befördern. Eine Vielzahl von Unterbändern entsteht in Materialien mit komplexer Kristallstruktur, die beispielsweise Untergitter ausbilden.

Außerdem ist es notwendig, dass Stöße zwischen Elektronen und Gitterschwingungen, also Stöße zwischen Elektronen und Phononen, möglichst vermieden werden, um die Rekombination von Elektronen und Löchern zu vermeiden. Die Bewegung von Elektronen und Phononen muss möglichst entkoppelt werden.

Es besteht weiterhin Bedarf an photovoltaisch aktiven Materialien, die einen hohen Wirkungsgrad aufweisen und für unterschiedliche Anwendungsbereiche ein geeignetes Eigenschaftsprofil zeigen. Die Forschung auf dem Gebiet der photovoltaisch aktiven Materialien ist noch in keiner Weise als abgeschlossen zu betrachten, so dass weiterhin Nachfrage nach unterschiedlichen Photovoltaik-Materialien besteht.

Aufgabe der vorliegenden Erfindung ist die Bereitstellung von photovoltaisch aktiven Materialien und diese enthaltenden Photovoltaik-Zellen, die die Nachteile der bestehenden Materialien und Zellen vermeiden und insbesondere höhere Wirkungsgrade aufweisen.

Die Aufgabe wird erfindungsgemäß gelöst durch eine Photovoltaik-Zelle mit einem photovoltaisch aktiven Halbleitermaterial aus mehreren Metallen oder Metalloxiden, die dadurch gekennzeichnet ist, dass das photovoltaisch aktive Material ausgewählt ist aus einem p- oder n-dotierten Halbleitermaterial aus einer ternären Verbindung der allgemeinen Formel (I)

$$Me_x S_y^A S_z^B \qquad\qquad (I)$$

mit

Me        = Al, Ti, Zr, V, Nb, Ta, Cr, Mo, W, Mn, Fe, Co, Ni, Cu oder Ag,

$S^A$, $S^B$    = B, C, Si, Ge, Sb, Se oder Te,

wobei $S^A$ und $S^B$ jeweils aus verschiedenen Gruppen des Periodensystems der Elemente stammen,
x, y, z unabhängig voneinander sind und Werte von 0,01 bis 1 annehmen können,
und wobei der Gewichtsanteil von $S^A$ und $S^B$ zusammen mehr als 30 % beträgt, bezogen auf das gesamte Halbleitermaterial,
oder einem Mischoxid der allgemeinen Formel (II)

$$[(CaO)_u \cdot (SrO)_v \cdot (BaO)_w \cdot (1/2\ Bi_2O_3)_x]_f \cdot \frac{2n+a}{2} \cdot (\{k\}\ Me^nO_{\frac{n}{2}} \cdot \{2-k\} \cdot Me^{n+a}O_{\frac{n+a}{2}}) \quad (II)$$

mit

Me     = Fe, Cu, V, Mn, Sn, Ti, Mo, W

n       = ganze Zahl von 1 bis 6,

a       = 1 oder 2,

f       = Zahl von 0,2 bis 5,

k       = Zahl von 0,01 bis 2, vorzugsweise von 0,01 bis 1,99, z.B. 1,

u+v+w+x= 1.

Die erfindungsgemäßen Photovoltaik-Zellen bereichern zum einen ganz allgemein die Palette der verfügbaren Photovoltaik-Zellen. Durch die unterschiedlichen chemischen Systeme können unterschiedliche Anforderungen in verschiedenen Anwendungsbereichen der Photovoltaik-Zellen erfüllt werden. Die erfindungsgemäßen Photovoltaik-Zellen erweitern damit die Anwendungsmöglichkeiten dieser Elemente unter unterschiedlichen Bedingungen beträchtlich.

Die Photovoltaik-Zelle enthält neben dem photovoltaisch aktiven Material vorzugsweise optisch transparente, elektrisch leitfähige Deckschichten wie Indium-Zinn-Oxid sowie elektrisch leitfähige Substratmaterialien, zwischen denen sich das photovoltaisch aktive Material befindet.

Die Erfindung betrifft Halbleitermaterialien, ausgenommen ternäre Verbindungen aus $AlB_{12}$ und $SiB_6$.

Nachstehend werden bevorzugte Halbleitermaterialien näher erläutert.

In den temären Verbindungen der allgemeinen Formel (I) sind $S^A$ und $S^B$ vorzugsweise ausgewählt aus B, C, Ge, Sb und Te.

Vorzugsweise ist in diesem Halbleitermaterial Me ausgewählt aus einer der folgenden Gruppen:

1) Al, Ti, Zr
2) V, Nb, Ta
3) Cr, Mo, W
4) Mn, Fe, Co, Ni
5) Cu, Ag.

Der Anteil an Dotierungselementen beträgt bis zu 0,1 Atom-% in der Legierung oder $10^{18}$ bis $10^{20}$ Ladungsträger pro Kubikzentimeter. Höhere Ladungsträgerkonzentrationen bewirken nachteilige Rekombinationen und damit eine reduzierte Ladungsbeweglichkeit. Dotiert wird mit Elementen, die einen Elektronenüber- oder -unterschuss im Kristallgitter bewirken, z. B. mit Iod für n-Halbleiter und Erdalkalielementen für p-Halbleiter, sofern ein 3/5- oder 3/6-Halbleiter vorliegt.

Eine weitere Möglichkeit der Dotierung ergibt sich dadurch, dass man gezielt durch unteroder überstöchiometrische Zusammensetzungen Löcher oder Elektronen in die Materialien einbringt und sich damit einen zusätzlichen Dotierschritt erspart.

Dotierelemente können auch über die wässrigen Lösungen von Metallsalzen eingebracht werden, die anschließend in der Mischung getrocknet werden. Anschließend werden die Metallkationen z.B. durch Wasserstoff bei erhöhten Temperaturen reduziert oder verbleiben ohne Reduktion im Material. Bevorzugt erfolgt die p- oder n-Dotierung durch Wahl der Mengenverhältnisse der Verbindungen oder die p-Dotierung mit Alkalimetallen und die n-Dotierung mit Sb, Bi, Se, Te, Br oder I (siehe WO 92/13811).

Die erfindungsgemäßen Materialien der allgemeinen Formel (I) werden nach bekannten Verfahren hergestellt, die Elementverbindungen z.B. durch Sintern der Elementpulver bei hohen Temperaturen, jedoch unterhalb des Schmelzpunkts, oder durch Schmelzen im Hochvakuum sowie anschließendes Pulverisieren und Sintern oder durch Schmelzen der Mischung der Elementpulver und Abkühlung.

In den Mischoxiden der allgemeinen Formel (II) bedeuten n die Oxidationsstufe des Metalls Me und f einen Stöchiometriefaktor. f hat einen Wert im Bereich von 0,2 bis 5, vorzugsweise von 0,5 bis 2, besonders bevorzugt von 1. a gibt die Differenz der beiden unterschiedlichen Oxidationsstufen von Me an.

Für den Stöchiometriefaktor f können als bevorzugte Bereiche Zahlen von 0,2 bis 0,99, der Wert 1, Zahlen von 1,01 bis 2 und Zahlen von 2,01 bis 5 angegeben werden. Es handelt sich um jeweils bevorzugte Ausrührungsformen der Erfindung.

k gibt den Anteil der Oxidationsstufen an.

Der Inhalt der Klammer

$$(\{k\}\ Me^nO_{\frac{n}{2}} \cdot \{2-k\} \cdot Me^{n+a}O_{\frac{n+a}{2}})$$

kann bevorzugt konkret sein:

FeO // $Fe_2O_3$
$Cu_2O$ // CuO
VO // $V_2O_3$
$V_2O_3$ // $V_2O_5$
$VO_2$ // $V_2O_5$
$VO_2$ // $V_2O_3$
MnO // $Mn_2O_3$
$Mn_2O_3$ // $Mn_2O_3$
SnO // $SnO_2$
TiO // $Ti_2O_3$
$Ti_2O_3$ // $TiO_2$
$MoO_2$ // $MoO_3$ oder
$WO_2$ // $WO_3$, insbesondere bevorzugt konkret

FeO $\cdot$ 1/2 $Fe_2O_3$
1/2 $Cu_2O \cdot$ CuO
VO $\cdot$ 1/2 $V_2O_3$
$V_2O_3 \cdot V_2O_5$
$VO_2 \cdot$ 1/2 $V_2O_5$
$VO_2 \cdot$ 1/2 $V_2O_3$
MnO $\cdot$ 1/2 $Mn_2O_3$
$Mn_2O_3 \cdot Mn_2O_3$
SnO $\cdot$ $SnO_2$
TiO $\cdot$ 1/2 $Ti_2O_3$
1/2 $Ti_2O_3 \cdot TiO_2$
$MoO_2 \cdot MoO_3$ oder
$WO_2 \cdot WO_3$,

Die erfindungsgemäßen Mischoxide werden nach bekannten Verfahren hergestellt, vorzugsweise durch inniges Vermischen der Einzeloxide mit den bekannten keramischen Technologien, Pressen der Mischungen unter Druck zu Formlingen von beispielsweise quaderförmiger Gestalt und Sintern der Formlinge in inerter Atmosphäre, z.B. unter Argon, bei Temperaturen von 900 bis 1700 °C.

Die erfindungsgemäßen Materialien werden somit nach bekannten Verfahren hergestellt, die Elementverbindungen z. B. durch Sintern der Elementpulver bei hohen Temperaturen, jedoch unterhalb des Schmelzpunkts oder durch Schmelzen im Hochvakuum sowie anschließendes Pulverisieren und Sintern. Die Oxide werden z. B. durch Sintern der Pulvermischungen der Einzeloxide synthetisiert. Der Ausdruck kombinatorisch, wie er vorstehend benutzt wurde, bezieht sich gerade auf diese Herstellung, insbesondere das Sintern.

Die photovoltaisch aktiven Mischoxide lassen sich auch durch Reaktivsintern der entsprechenden Metallmischungen in Luft bei erhöhten Temperaturen herstellen. Aus wirtschaftlichen Gründen ist es auch sinnvoll, Mischungen von Oxiden und Metallen einzusetzen.

Die Materialien können verformt werden durch Extrusion zu Bändern und gegebenenfalls Verstrecken der Bänder während der nachfolgenden Abkühlung unterhalb des Materialschmelzpunktes. Die Herstellung von Photovoltaik-Zellen kann durch Aufbringen von Schichten des Halbleitermaterials auf leitfähige Substrate mittels Siebdruck erfolgen. Eine elektrische Kontaktierung kann durch Bedampfen erfolgen.

Ein weiterer Gegenstand der Erfindung ist die Optimierung der Materialien hinsichtlich des Wirkungsgrads.

Es liegt auf der Hand, dass bei Variation der Komponenten um beispielsweise 5 Atom-% sehr viele Materialien synthetisiert und geprüft werden müssen. Diese Aufgabe kann mit kombinatorischen Methoden gelöst werden. Dazu können Elementlegierungen oder Oxidmischungen oder Mischungen von Elemente mit Oxiden mit gradueller Variation der Zusammensetzung als Funktion der Längenkoordination auf einem Substrat erzeugt werden, indem man die Elemente oder bereits binäre Legierungen von entsprechenden Targets aus auf einem mit einer Lochmaske versehenen Substrat erzeugt, wobei sich die Elementzusammensetzung je nach Entfernung von den Targets oder je nach Sputterwinkel ändert. Anschließend wird die Maske entfernt, und die erzeugten Dünnschicht-"Dots" werden zu den eigentlichen Materialien gesintert. Der Ausdruck "Dot" bezeichnet dabei räumlich voneinander getrennte Punkte oder Bereiche des Materials auf einem Substrat, die im wesentlichen gleiche Ausmaße aufweisen und vorzugsweise in regelmäßigen Abständen angeordnet sind, so dass sich ein Array ergibt. "Array" bedeutet die zweidimensionale, im wesentlichen gleichmäßig beabstandete Anordnung von Dots auf einer Substratfläche. Es ist auch möglich, Element- und Oxidpulver mit Korngrößen unterhalb 5 µm in einem inerten Suspensionsmittel wie Kohlenwasserstoffen unter Mitwirkung eines Dispergiermittels zu genügend stabilen Suspensionen zu suspendieren und Mischungen der Suspensionen wie bei den Oxiden beschrieben als Tröpfchen abzulegen, das Suspensionsmittel zu verdampfen und die so erzeugte Pulvermischungen auf dem Substrat zu sintern.

Als inertes, temperatur- und diffusionsstabiles Substratmaterial wird neben metallischen Substraten Siliziumcarbid bevorzugt, das auch genügend elektrisch leitfähig ist.

Dünnschicht-Dots der Oxide können auf einer Substratfläche erzeugt werden, indem über Dosierautomaten Mischungen von Salzen, vorzugsweise von Nitraten oder sonstigen löslichen Verbindungen in Form von Tropfen variabler Zusammensetzung abgelegt werden, das Lösungsmittel, vorzugsweise Wasser, verdampft wird, durch Temperaturerhöhung die Nitrate oder Verbindungen in die Oxide überführt werden und die Oxidmischungen in ihrer Gesamtheit anschließend gesintert werden.

Pro Substratplatte mit Maßen von in der Größenordnung $10 * 10 \text{ cm}^2$ werden 1.000 bis 10.000 Dots mit Abmessung (Durchmessern) von 0,2 bis 2 mm aufgebracht.

Der schnelle und zuverlässige Test der Materialien ist essentiell. Erfindungsgemäß kann dazu nachstehendes Analyseverfahren durchgeführt werden:

Die Erfindung betrifft ein Verfahren zur kombinatorischen Herstellung und Testung von Halbleitermaterialien für Photovoltaik-Zellen, bei dem man auf einem leitfähigen flächigen Substrat ein Array aus Dünnschicht-Dots der Halbleitermaterialien mit unterschiedlicher Zusammensetzung erzeugt, das Substrat vorzugsweise unter einem inerten Gas wie Stickstoff oder Argon mit dem Array auf eine gewünschte Meßtemperatur temperiert und die Dots jeweils mit einem Meßstift kontaktiert, wobei unter Beleuchtung die Spannung ohne Belastung, Strom und Spannung bei sich verminderndem Lastwiderstand und/oder der Kurzschlußstrom gemessen, nachfolgend gespeichert und ausgewertet werden. Die Beleuchtungsstärke kann dabei variiert werden.

Für die Methode werden die auf dem metallischen bzw. Silicumcarbid-Substrat befindlichen Dots z. B. mittels einer Mikrofeinschleifscheibe auf eine einheitliche Höhe abgeschliffen, und dabei wird gleichzeitig eine ebene Fläche geringer Rauhtiefe geschaffen. Man bringt die Substratplatte auf eine Meßtemperatur und kontaktiert mit einem Meßstift unter definierter Auflagekraft die Dots.

Während der Meßstift aufliegt, werden die Spannung ohne Belastung, Strom und Spannung bei sich verminderndem Lastwiderstand sowie der Kurzschlußstrom gemessen. Eine rechnergesteuerte Meßapparatur benötigt zum Vermessen eines Materials inklusive Verfahren an den nächsten Dot um 10 Sekunden, was pro Tag die Vermessung von ca. 10.000 Dots bei einer Temperatur ermöglicht. Arbeitet man mit mehreren Meßstiften parallel, so können entsprechend mehr Dots vermessen werden. Die Meßwerte und Kurven können gespeichert und grafisch aufbereitet werden, so dass eine grafische Darstellung auf einen Blick die besseren Materialien anzeigt, deren Zusammensetzung man dann mit üblichen Methoden analysiert. Vorzugsweise wir unter Inertgas gearbeitet.

Die Erfindung betrifft auch ein Array aus mindestens 10 unterschiedlichen erfindungsgemäßen Halbleitermaterialien auf einem leitfähigen Substrat.

Die erfindungsgemäßen Materialien werden gemäß dem Stand der Technik, wie er z. B. WO 98/44562, US 5,448,109, EP-A-1 102 334 oder US 5,439,528 dargestellt ist, in Module eingebracht und in diesen in Serie geschaltet.

**Patentansprüche**

1. Photovoltaik-Zelle mit einem photovoltaisch aktiven Halbleitermaterial aus mehreren Metallen oder Metalloxiden, **dadurch gekennzeichnet, dass** das photovoltaisch aktive Material ausgewählt ist aus einem

    p- oder n-dotierten Halbleitermaterial aus einer ternären Verbindung der allgemeinen Formel (I)

$$Me_x S_y^A S_z^B \qquad\qquad (I)$$

mit

Me = Al, Ti, Zr, V, Nb, Ta, Cr, Mo, W, Mn, Fe, Co, Ni, Cu oder Ag,

$S^A$, $S^B$ = B, C, Si, Ge, Sb, Se oder Te,

wobei $S^A$ und $S^B$ jeweils aus verschiedenen Gruppen des Periodensystems der Elemente stammen,
x, y, z unabhängig voneinander sind und Werte von 0,01 bis 1 annehmen können,
und wobei der Gewichtsanteil von $S^A$ und $S^B$ zusammen mehr als 30 % beträgt, bezogen auf das gesamte Halbleitermaterial,
oder einem Mischoxid der allgemeinen Formel (II)

$$[(CaO)_u \cdot (SrO)_v \cdot (BaO)_w \cdot (1/2\,Bi_2O_3)_x]_f \cdot \frac{2n+a}{2} \cdot (\{k\} \cdot Me^n O_{\frac{n}{2}} \cdot \{2-k\} \cdot Me^{n+a} O_{\frac{n+a}{2}}) \quad (II)$$

mit

Me = Fe, Cu, V, Mn, Sn, Ti, Mo, W

n = ganze Zahl von 1 bis 6,

a = 1 oder 2,

f = Zahl von 0,2 bis 5,

k = Zahl von 0,01 bis 2,

u+v+w+x= 1.

2. Photovoltaik-Zelle nach Anspruch 1, **dadurch gekennzeichnet, dass** im Halbleitermaterial $S^A$ und $S^B$ ausgewählt sind aus B, C, Ge, Sb und Te.

3. Photovoltaik-Zelle nach Anspruch 1 oder 2, **dadurch gekennzeichnet, dass** im Halbleitermaterial Me ausgewählt ist aus Al, Ti und Zr.

4. Photovoltaik-Zelle nach Anspruch 1 oder 2, **dadurch gekennzeichnet, dass** im Halbleitermaterial Me ausgewählt ist aus V, Nb und Ta.

5. Photovoltaik-Zelle nach Anspruch 1 oder 2, **dadurch gekennzeichnet, dass** im Halbleitermaterial Me ausgewählt ist aus Cr, Mo oder W.

6. Photovoltaik-Zelle nach Anspruch 1 oder 2, **dadurch gekennzeichnet, dass** im Halbleitermaterial Me ausgewählt ist aus Mn, Fe, Co und Ni.

7. Photovoltaik-Zelle nach Anspruch 1 oder 2, **dadurch gekennzeichnet, dass** im Halbleitermaterial Me ausgewählt ist aus Cu und Ag.

8. Photovoltaik-Zelle nach Anspruch 1, **dadurch gekennzeichnet, dass** für das Mischoxid f einen Wert im Bereich von 0,2 bis 0,9 oder 1 oder von 1,01 bis 2 oder von 2,01 bis 5 aufweist.

9. Photovoltaisch aktives Material, wie es in einem der Ansprüche 1 bis 8 definiert ist, ausgenommen ternäre Verbindungen aus $AlB_{12}$ und $SiB_6$.

**10.** Verfahren zur Herstellung von Halbleitermaterialien gemäß Anspruch 9 durch Sintern oder Zusammenschmelzen und nachfolgend Sintern von Mischungen der Elementpulver oder durch Sintern von Mischungen der Oxidpulver, Extrusion zu Bändern und gegebenenfalls Verstrecken der Bänder während der nachfolgenden Abkühlung unterhalb des Materialschmelzpunktes.

**11.** Verfahren zur kombinatorischen Herstellung und Testung von Halbleitermaterialien für Photovoltaik-Zellen nach Anspruch 9, bei dem man auf einem leitfähigen flächigen Substrat ein Array aus Dünnschicht-Dots der Halbleitermaterialien mit unterschiedlicher Zusammensetzung erzeugt, das Substrat mit dem Array auf eine gewünschte Meßtemperatur temperiert und die Dots jeweils mit einem Meßstift kontaktiert, wobei unter Beleuchtung die Spannung ohne Belastung, Strom und Spannung bei sich verminderndem Lastwiderstand und/oder der Kurzschlußstrom gemessen, nachfolgend gespeichert und ausgewertet werden.

**12.** Array aus mindestens 10 unterschiedlichen Halbleitermaterialien gemäß Anspruch 9 auf einem leitfähigen Substrat.

**13.** Verfahren zur Herstellung von Photovoltaik-Zellen nach einem der Ansprüche 1 bis 8 durch Aufbringen von Schichten des Halbleitermaterials auf leitfähige Substrate mittels Siebdruck.